# EUROPEAN PATENT APPLICATION

(11) **EP 1 675 229 A1**
(43) Date of publication of application: **28.06.2006**
(21) Application number: 05027247.5
(22) Date of filing: 13.12.2005
(51) Int. Cl.: H01S 5/02, H01S 5/024

(54) **LD bar with recesses for optimum soldering to a heat sink**

(30) Priority: 24.12.2004 JP 2004374045
(71) Applicant: FANUC LTD, Minamitsuru-gun, Yamanashi 401-0597 (JP)
(72) Inventor: Nishikawa, Yuji, Room 14-408, FANUC, Minamitsuru-gu,Yamanashi 401-0511 (JP); Ohyama, Akinori, Room 11-201, FANUC, Minamitsuru-gu,Yamanashi 401-0511 (JP); Miyata, Ryusuke, Room 12-403, FANUC, Minamitsuru-gu,Yamanashi 401-0511 (JP)
(74) Representative: Schmidt, Steffen J.

(57) **Abstract**

A semiconductor laser apparatus (10) is provided and comprises a mounting substrate (6), a semiconductor laser chip (1) joined to a mounting surface (6a) of said mounting substrate (6) with solder (5), emitters (3) and non-active mesa portions (4) formed on a joining surface (1a) of said semiconductor laser chip (1) to be joined to said mounting surface (6a) of said mounting substrate (6); each of said emitters (3) and non-active mesa portions (4) being separated from the other by component separating channels (2) formed on said joining surface (1a) of said mounting substrate (1); wherein at least one mesa separating channel for separating said non-active mesa portion (4) is formed in said non-active mesa portion (4) at the joining surface (1a) of the semiconductor chip (1). Thereby, the joining strength of the solder is sufficient for preventing the separation of the semiconductor laser chip from the mounting substrate. The solder between the joining surface of the semiconductor laser chip and the mounting surface of the mounting substrate includes fillets (9a, 9b) disposed in the inner walls of the component separating channel and the mesa separating channel. The fill factor is preferably 50% or more.

## Description

### BACKGROUND OF THE INVENTION

### 1. Field of the Invention

The present invention relates to a semiconductor laser apparatus and, particularly, to a semiconductor laser apparatus improved in structure to enhance the strength of a solder join joining the semiconductor laser chip to a mounting substrate thereof.

### 2. Description of the Related Art

A semiconductor laser apparatus, particularly one using, as a light source, a one-dimensional LD array constituted by a number of laser diode (LD) elements arranged so that light emitting areas of the respective LD elements are linear, has been often used as an excitation source for a solid state laser such as YAG laser (yttrium-aluminum-garnet laser). For example, when a semiconductor laser apparatus disclosed in W. Koechner "Solid-State Laser Engineering" (Springer-Verlag, 4th Ed., 1996) is used as an excitation source for the solid state laser, there is an advantage in that the exciting efficiency becomes higher and a life is longer than when a conventional discharge lamp such as a xenon lamp is used.

One way to form the one-dimensional LD array is to separate the semiconductor laser chip into an emitter (light emitting portion) and a non-active mesa portion by component separating channels. As disclosed in the Study of Lasers by Kan and others (23 (1995) 541.), a pitch of the emitter is approximately in a range from 100 to 500 µm. Also, a width of the non-active mesa portion is approximately in a range from 50 to 350µm.

In this regard, when the semiconductor laser chip is driven, heat which is as large as a light output is generated. If the temperature of the light emitting portion in the semiconductor laser chip becomes high due to such heat, the temperature distribution of the semiconductor laser chip becomes ununiform, which may cause the light emitting portion; i.e., the emitter to deteriorate, whereby the reliability of the semiconductor laser apparatus is lowered.

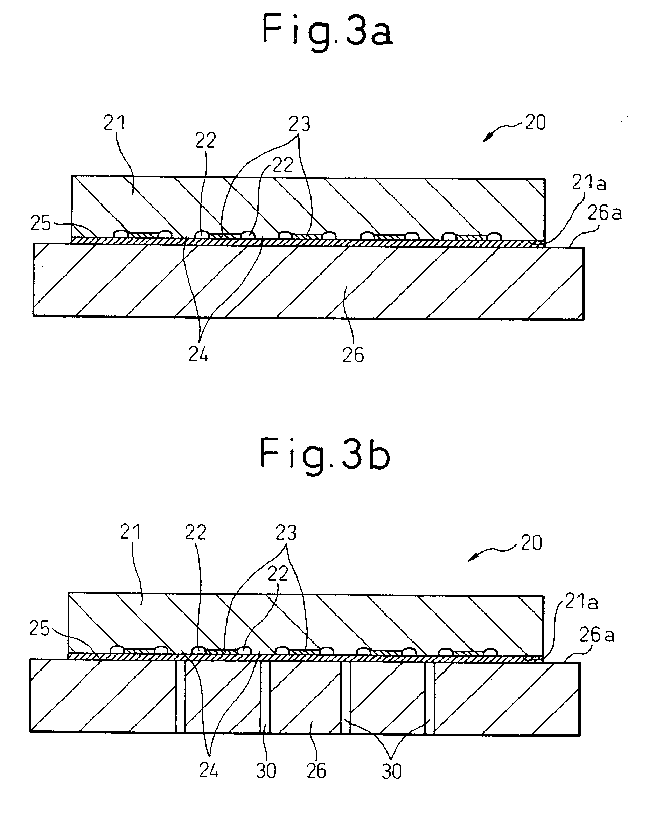

Fig. 3a is a sectional view of a prior art semiconductor laser apparatus wherein a semiconductor laser chip is mounted on a mounting substrate. As shown in Fig. 3a, the semiconductor apparatus 20 is constituted by the semiconductor laser chip 21 and a mounting substrate 26. To electrically connect the semiconductor laser chip 21 to the mounting substrate 26, a joining surface 21a of the semiconductor laser chip 21 is joined to a mounting surface 26a of the mounting substrate 26 with solder 25. Note the mounting substrate may be a substrate for directly mounting the semiconductor laser chip 21 thereon, and/or a cooler for reducing heat of the semiconductor laser chip 21.

As illustrated, there is a plurality of component separating channels 22 on the joining surface 21a of the semiconductor laser chip 21. The semiconductor laser chip 21 has a one-dimensional LD array structure wherein emitters 23 and non-active mesa portions 24 are separated from each other by the component separating channels 22. To avoid the distribution of heat from the emitters in the one-dimensional LD array becoming unbalanced and to maintain substantially uniform the temperature distribution within the one-dimensional LD array, emitters 23 having the same width are arranged at the same pitch as shown in Fig. 3a so that the non-active mesa portions 24 between the adjacent emitters preferably have approximately the same width.

Fig. 3b is a view similar to Fig. 3a of a prior art semiconductor laser apparatus as disclosed in H. P. Godfried et. al. "Use of CVD diamond in high-power CO₂ lasers and laser diode arrays" (Proceedings of SPIE. Vol. 3889 pp. 553-563). A plurality of channels 30 are formed in the mounting substrate 26 in Fig. 3b. The non-active mesa portions 24 of the semiconductor laser chip 21 are positioned above these channels 30. Due to such a structure, in the semiconductor laser apparatus disclosed in the document of H. P. Godfried et al., it is possible to relax the residual stress which may be generated in the semiconductor laser chip 21 to some extent.

In the semiconductor laser apparatuses 20 disclosed in these three documents, however, there are cases wherein residual stress is generated in the area joined by solder 25 because the difference in thermal expansion coefficient between the semiconductor laser chip 21 and the mounting substrate 26 is large. By the repetition of the drive/stop of the semiconductor laser chip 21, a temperature cycle may be generated to cause the partial separation of the joining portion of the solder 25 by the effect of the residual stress, resulting in the reduction of the life of the semiconductor laser apparatus 20 as well as the reliability thereof.

In addition, if the joining portion between the semiconductor laser chip 21 and the mounting substrate 26 is not uniform, the cooling performance of the mounting substrate 26 is deteriorated, which also causes the reliability of the semiconductor device apparatus 20 to fall.

Further, as disclosed in the document of H. P. Godfried et. al. wherein a plurality of channels 30 are formed in the mounting substrate 26, a positioning operation is conducted in such a manner that each of the non-active mesa portions 24 in the semiconductor laser chip 21 is arranged above the respective channel 30. In this regard, when the emitter 23 is arranged above the channel 30 by erroneous positioning, the cooling efficiency for the semiconductor laser chip 21 is lowered to result in the deterioration of the reliability of the semiconductor laser apparatus 20, whereby it is necessary to conduct such a positioning operation with a high accuracy. However, such a highly accurate positioning operation is troublesome and prolongs the production time of the semiconductor laser apparatus.

The present invention has been made in view of the above-mentioned circumstances, and an object thereof is to provide a semiconductor laser apparatus capable of obtaining a joining strength of the solder to sufficiently avoid the separation of the semiconductor laser chip from the mounting substrate even if the residual stress is generated.

### SUMMARY OF THE INVENTION

To achieve the above-mentioned object, according to a first aspect, a semiconductor laser apparatus is provided, comprising a mounting substrate, a semiconductor laser chip joined to a mounting surface of said mounting substrate with solder, emitters and non-active mesa portions formed on a joining surface of said semiconductor laser chip to be joined to said mounting surface of said mounting substrate; each of said emitters and non-active mesa portions being separated from the other by component separating channels formed on a joining surface of said mounting substrate or semiconductor laser chip; wherein at least one mesa separating channel for separating said non-active mesa portion is formed in said non-active mesa portion at the joining surface of the semiconductor laser chip.

According to a second aspect, said solder between said joining surface of said semiconductor laser chip and said mounting surface of said mounting substrate includes fillets disposed in inner walls of said component separating channels and said mesa separating channels.

That is, in the first and second aspects, a plurality of non-active mesa portions are formed by at least one mesa separating channel. The solder between the joining surface of the semiconductor laser chip and the mounting surface of the mounting substrate partially flows into both of the component separating channel and the mesa separating channel on the joining surface to form fillets on both sides of the inner walls in these separating channels. Accordingly, in comparison with the prior art wherein a fillet is formable solely in the component separating channel, it is possible to increase the joining strength of the solder, and to prevent the separation of the semiconductor laser chip from the mounting substrate from occurring even if the residual stress generates. Also, when the mesa separating channels are evenly formed all over the joining surface of the semiconductor laser chip, the fillets of the mesa separating channels are evenly formed all over the joining surface of the semiconductor laser chip. Accordingly, a firm join between the semiconductor laser chip and the mounting substrate is secured all over the joining surface, resulting in an assured cooling performance of the mounting substrate over all of the joining surface.

According to a third aspect, in the first or second aspect, said semiconductor laser chip is a one-dimensional LD array wherein a ratio of a sum of widths of said emitters to a width of said one-dimensional LD array is 50% or more.

That is, according to the third aspect, by determining the ratio of a sum of widths of the emitters to the width of the one-dimensional LD array; i.e., a fill factor, it is possible to obtain a sufficiently high output while maintaining the satisfactory joining strength.

According to a fourth aspect, in any one of the first to third aspects, a recess is formed in at least a part of said mounting surface of the mounting substrate at which an end of said semiconductor laser chip is disposed, and said solder further includes a fillet disposed in an inner wall of said recess.

That is, in the fourth aspect, it is possible to further increase the joining strength between the semiconductor laser chip and the mounting substrate due to the fillet formed in the recess of the mounting substrate.

According to the above-mentioned respective aspects, a common effect is achievable that the joining strength of the solder is obtainable, and is sufficient for avoiding the separation of the semiconductor laser chip from the mounting substrate, by forming the fillets in the mesa separating channels, even if the residual stress generates.

Further, according to the third aspect, it is possible to obtain a sufficiently high output while maintaining a satisfactory joining strength.

Further, according to the fourth aspect, the joining strength between the semiconductor laser chip and the mounting substrate is further enhanced due to the fillet formed in the recess of the mounting substrate.

These and other objects, features and advantages of the present invention will be more apparent in light of the detailed description of exemplary embodiments thereof as illustrated in the drawings.

### BRIEF DESCRIPTION OF THE DRAWINGS

In the drawings:
Fig. 1a is a sectional view of a semiconductor laser apparatus based on a first embodiment of the present invention;
Fig. 1b is a partial enlarged view of the semiconductor laser apparatus shown in Fig. 1a;
Fig. 2 is a sectional view of a semiconductor laser apparatus based on a second embodiment of the present invention;
Fig. 3a is a sectional view of a prior art semiconductor laser apparatus formed by mounting a semiconductor laser chip on a mounting substrate; and
Fig. 3b is a sectional view of another prior art semiconductor laser apparatus formed by mounting a semiconductor laser chip on a mounting substrate.

### DETAILED DESCRIPTION

The preferred embodiments of the present invention will be described below with reference to the attached drawings wherein the same reference numerals are used for denoting the same components. For the purpose of enhancing the understanding, the scales may be properly changed in these drawings.

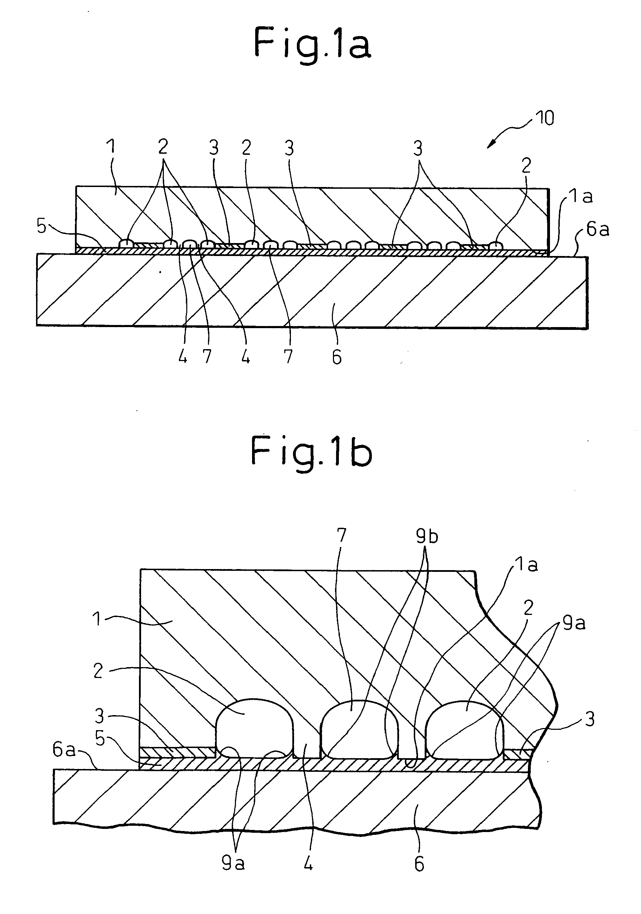

Fig. 1a is a sectional view of a semiconductor laser apparatus based on a first embodiment of the present invention. As shown in Fig. 1a, a semiconductor laser apparatus 10 includes a semiconductor laser chip 1 and a mounting substrate 6. On a joining surface 1a of the semiconductor laser chip 1 to be joined to the mounting substrate 6, a plurality of emitters 3 are provided. The respective emitters 3 are separated from a plurality of non-active mesa portions 4 on the joining surface 1a by a plurality of component separating channels 2 formed on the joining surface 1a. In Fig. 1a, the semiconductor laser chip 1 is a one-dimensional LD array of a multi-stripe structure wherein a plurality of emitters 3 and a plurality of non-active mesa portions 4 to have an approximately equal width to those of emitters 3 are alternately arranged in one direction, while separating from each other by component separating channels 2. In Fig. 1a, while one emitter 3 is disposed via the component separating channels 2 between adjacent two non-active mesa portions 4, a plurality of emitters 3 of the same size may be disposed between the two non-active mesa portions unless the characteristic of the semiconductor laser chip 1 is influenced.

As a large amount of heat is generated when the semiconductor laser apparatus 10 is driven, the semiconductor laser chip 1 is joined to a cooler by solder for preventing the heat from generating. The generally used cooler is of a type having a passage therein for passing a coolant therethrough. The cooler may be a heat sink without such a passage.

A mounting substrate having a thermal expansion coefficient relatively closer to that of the semiconductor laser chip 1 may be provided between the semiconductor chip 1 and the cooler. Generally speaking, as the difference in thermal expansion coefficient is relatively large between the semiconductor laser chip 1 and the cooler, there may be a case wherein the residual stress generates in the joint portion of the solder 5. However, such a residual stress can be relaxed to a some extent by using a mounting substrate as a buffer. In this case, solder is used both for a joint portion between the semiconductor laser chip 1 and the mounting substrate and another joint portion between the mounting substrate and the cooler.

As described above, according to the present invention, the semiconductor laser chip 1 is directly coupled to either the mounting substrate or the cooler, or coupled via the mounting substrate to the cooler. Hereinafter, in this specification, the mounting substrate, the cooler or both thereof coupled to the semiconductor laser chip 1 are referred to as "a mounting substrate". In Fig. 1a, the semiconductor laser chip 1 is joined to the mounting surface 6a of such a mounting substrate 6 with solder 5.

The mounting substrate 6 is usually made of copper, a copper compound or a composite of copper and copper oxide whereby a total cost of the resultant semiconductor laser apparatus 10 is inexpensive. On the other hand, as the material of the solder 5, a two or more-component alloy containing relatively inexpensive Sn and material forming eutectic crystal with Sn, such as SnPb eutectic crystal solder may be utilized.

In this regard, when the mounting substrate 6 is made of copper and the solder 5 is made of material containing Sn, there may be a case wherein the formation of intermetallic compound proceeds after the soldering, and the joining strength between the semiconductor laser chip 1 and the mounting substrate 6 deteriorates as the time passes. To avoid such a disadvantage, when the mounting substrate 6 is made of copper and the solder 5 is made of material containing Sn, preferably, a thin coating of metal, for example, of Ni, Ti, Pt or Cr is preliminarily formed on the mounting surface 6a of the mounting substrate 6 by vapor deposition or the like.

The semiconductor laser apparatus 10 of such a structure is used as a source for exciting a solid state laser such as YAG laser. As is well known, when a voltage is applied to an electrode (not shown) connected to the semiconductor laser chip 1, a laser beam is output from the emitter 3 of the semiconductor laser chip 1 in the direction perpendicular to the paper surface.

As shown in Fig. 1a, according to the inventive semiconductor laser apparatus 10, each of the plurality of mesa separating channels 7 is formed in the non-active mesa portion 4 on the joining surface 1a of the semiconductor laser chip 1. While one mesa separating channel 7 is formed in the non-active mesa portion 4 corresponding thereto in Fig. 1a, a plurality of mesa separating channels 7 may be formed in one non-active mesa portion 4 if a width of the non-active mesa portion 4 is larger.

Fig. 1b is a partial enlarged view of the semiconductor laser apparatus shown in Fig. 1a. As shown in Fig. 1b, when the joining surface 1a of the semiconductor laser chip 1 is joined to the mounting surface 6a of the mounting substrate 6 with the solder 5, the solder 5 partially flows along the inner wall of the component separating channel 2. Thereby, fillets 9a of the solder 5 are partially formed on the opposite sides of the inner wall of the component separating channel 2. Further, as the mesa separating channel 7 is formed in the non-active mesa portion 4 in the present invention, the solder 5 partially flows along the inner wall of the mesa separating channel 7 to form fillets 9b on the opposite sides of the inner wall of the mesa separating channel 7 in the same manner as described above.

In such a manner, according to the present invention, both of the fillets 9a in the component separating channel 2 and the fillets 9b in the mesa separating channel 7 are formed. On the other hand, as the mesa separating channels 7 are not formed in the prior art, only the fillets 9a in the component separating channel 2 are formed even if the solder is used. Accordingly, in the inventive semiconductor laser apparatus, it is possible to increase the joining strength of the solder 5 by the fillets 9b in the mesa separating channel 7 in comparison with the prior art. In other words, even if the solder 5 deteriorates due to the residual stress upon the driving of the semiconductor laser apparatus 10, the joining strength sufficient for avoiding the separation of semiconductor laser chip 1 is obtained by the fillets 9a, 9b in the present invention. Accordingly, it is possible to prevent the semiconductor laser chip 1 from separating from the mounting substrate 6 according to the present invention.

Usually, as the emitters 3 are uniformly arranged all over the joining surface 1a of the semiconductor laser chip 1, it is also possible to uniformly form the mesa separating channels 7, for separating the non-active mesa portions 4, all over the joining surface 1a. In such a case, the fillets 9b of the solder are uniformly formed, whereby the firm joints are obtainable all over the joining surface 1a between the semiconductor laser chip 1 and the mounting substrate 6. As described before, when the mounting substrate 6 performs the function of the cooler, the cooling performance of the mounting substrate 6 is achievable all over the joining surface 1a, since the semiconductor laser chip 1 is uniformly joined to the mounting surface 1a.

In the prior art described before with reference to Fig. 3b, while channels 30 are formed in the mounting substrate 26 for relaxing the residual stress, such channels 30 are unnecessary, in the present invention, because the fillets 9a, 9b are provided to have the joining strength of the solder sufficient for preventing the separation of the semiconductor laser chip. As a result, according to the present invention, the high-accuracy positioning operation indispensable in the prior art can be eliminated, whereby the joining operation can be quickly carried out to save the production time of the semiconductor laser apparatus 10.

The mesa separating channels 7 are preferably formed on the joining surface 1a of the semiconductor laser chip 1 so that a ratio of a sum of widths of the emitters 3 to a width of the semiconductor laser chip 1; i.e., a fill factor; is 50% or more. By setting the fill factor in such a manner, it is possible to have a sufficiently high output while maintaining the joining strength at a desired level.

When the width of the non-active mesa portion 4 is further large as described before, a plurality of mesa separating channels 7 may be formed in one non-active mesa portion 4. In such a case, the number of the fillets 9b in the mesa separating channels 7 increases to further enhance the joining strength between the semiconductor laser chip 1 and the mounting substrate 6. In this regard, while the dimension of the component separating channel 2 is approximately equal to that of the mesa separating channel 7 in the illustrated embodiment, both the dimensions may be different from each other. If the dimension of the mesa separating channel 7 is smaller than that of the component separating channel 2, it is possible to form more mesa separating channels 7 in one non-active mesa portion 4 without enlarging the non-active mesa portion 4, and thus to form more fillets 9b.

As described before, as the difference in thermal expansion coefficient is relatively large between the semiconductor laser chip 1 and the cooler; i.e., the mounting substrate 6, there may be cases wherein the residual stress is generated in the joint portion of the solder 5. By repeating the drive/stop of the semiconductor laser apparatus 10, the temperature cycle causes the separation of the joint portion of the solder 5 due to the influence of the residual stress.

To reduce the residual stress, the mounting substrate 6 is preferably made of material having a thermal expansion coefficient equal or close to that of the semiconductor laser chip 1. Such material for the mounting substrate 6 is, for example, silicon, silicon carbide, aluminum nitride or alumina. If the material for the mounting substrate 6 is an insulator, a thin coating of metal is preferably formed on the mounting surface 6a of the mounting substrate 6 for the purpose of the electro-conduction. The thin coating may be a single layer or a plurality of layers selected from a group, for example, of Ni, Ti, Pt or Cr. Similarly, to reduce the influence of the residual stress, low-melting point solder such as two or more-component alloy containing In is preferably used for the solder 5. As the residual stress is reduced by such a constitution, the joining strength caused by the fillets 9a, 9b is further enhanced, as a result.

To improve the wettability of the solder 5 by removing an oxide film on the surface of the solder 5 when the joining operation using the solder 5 is carried out, a flux is often applied on the joining surface 1a of the semiconductor laser chip 1 and/or the mounting surface 6a of the mounting substrate 6. In such a case, as the emitter 3 of the semiconductor laser chip 1; that is, the laser beam emitting portion, is very close to (approximately 10µm or less) the solder 5 in the semiconductor laser apparatus 10, the residue of the flux may adhere to the laser beam emitting portion to disturb the emission of laser beam. Also, the flux may corrode the laser beam emission surface of the emitter 3 to lower the reliability of the semiconductor laser apparatus 10. Accordingly, when joined by the solder 5, a flux of a low-residue type is preferably used to minimize the influence of the flux residue.

In another embodiment, hydrogen gas may be used during the joining operation using the solder 5. In this case, as the oxide film is removed from the surface of the solder 5, due to reduction by hydrogen, to improve the wettability, the joining strength of the solder 5 is enhanced. When the flux is not used but hydrogen gas is used, the deterioration of the reliability of the semiconductor laser apparatus 10 based on the residue of the flux is avoidable.

When the use of the flux and/or hydrogen gas and the formation of the mesa separating channels 7 based on the present invention are combined together, the joining strength of the solder increases due to the formation of the fillets 9b as well as the operation of the flux and/or hydrogen gas, whereby the risk of the separation between the semiconductor laser chip 1 and the mounting substrate 6 is further reduced.

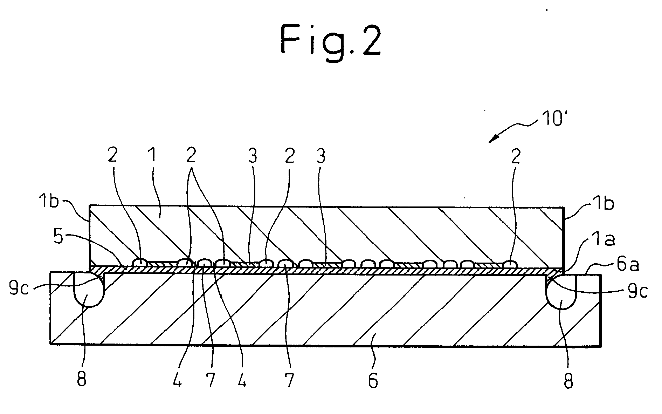

Fig. 2 is a sectional view of the inventive semiconductor laser apparatus based on a second embodiment. In Fig. 2, recesses 8 are formed on the mounting surface 6a of the mounting substrate 6. As illustrated, these recesses 8 are formed at positions corresponding to opposite edges 1b of the semiconductor laser chip 1. That is, the opposite edges 1b of the semiconductor laser chip 1 partially project over the recesses 8. Thereby, when the semiconductor laser chip 1 is joined to the mounting substrate 6 with the solder 5, the solder 5 partially flowing along the inner wall of the recess 8 wets an electrodes (not shown) located at each of the opposite edges 1b of the semiconductor laser chip 1. Thus, a fillet 9c is partially formed at a position on the inner wall of the recess 8 closer to a center of the mounting substrate 6.

As the fillet 9c formed in the recess 8 enhances the joining strength between the semiconductor laser chip 1 and the mounting substrate 6, it is possible to further reduce the risk of the separation of the semiconductor laser chip 1 during the drive of the semiconductor laser apparatus 10.

In addition, the component separating channels 2 and the mesa separating channels 7 formed in the semiconductor laser chip 1 and the recesses 8 formed on the mounting substrate 6 serve as a refuge space into which the solder 5 flows. Thereby, the fluidity of the solder 5 is increased as the numbers of the component separating channels 2, the mesa separating channels 7 and the recesses 8 increase, whereby the oxide film of the solder 5 is more easily broken. As a result, the wettability as well as the joining strength of the solders are also improved.

Although the recesses 8 are formed at the positions corresponding to the opposite edges of the semiconductor laser chip 1 in Fig. 2, they may be formed at other positions and the number and the dimension thereof may be changed as long as the fillets 9c can be formed while maintaining the reliability of the semiconductor laser apparatus 10 at a desired level.

While the semiconductor laser apparatuses 10 in the illustrated embodiments include a one-dimensional LD array, the present invention encompasses cases wherein a so-called two-dimensional LD array is included, formed by overlaying a semiconductor laser chip 1 on the upper surface of the other semiconductor laser chip 1 of the same structure. Also, the above-mentioned embodiments may be suitably combined to provide a new one which is also encompassed by the present invention.

Although the invention has been shown and described with exemplary embodiments thereof, it should be understood, by those skilled in the art, that the foregoing and various other changes, omissions and additions may be made therein and thereto without departing from the spirit and the scope of the invention.

## Claims

1. A semiconductor laser apparatus (10) including a mounting substrate (6), a semiconductor laser chip (1) joined to a mounting surface (6a) of said mounting substrate (6) with solder (5), emitters (3) and non-active mesa portions (4) formed on a joining surface (1a) of said semiconductor laser chip (1) to be joined to said mounting surface (6a) of said mounting substrate (6); each of said emitters (3) and non-active mesa portions (4) being separated from the other by component separating channels (2) formed on said joining surface (1a) of said mounting substrate (1); **characterized in that**
wherein at least one mesa separating channel (7) for separating said non-active mesa portion (4) is formed in said non-active mesa portion (4) at the joining surface (1a) of the semiconductor chip (1).

2. A semiconductor laser apparatus as defined by claim 1, wherein said solder (5) between said joining surface (1a) of said semiconductor laser chip (1) and said mounting surface (6a) of said mounting substrate (6) includes fillets (9a, 9b) disposed in inner walls of said component separating channels (2) and said mesa separating channels (7).

3. A semiconductor laser apparatus as defined by claim 1 or 2, wherein said semiconductor laser chip (1) is a one-dimensional LD array wherein a ratio of a sum of widths of said emitters (3) to a width of said one-dimensional LD array is 50% or more.

4. A semiconductor laser apparatus as defined by any one of claim 1 to 3, wherein a recess (8) is formed in at least a part of said mounting surface (6a) of the mounting substrate (6) at which an end of said semiconductor laser chip (1) is disposed, and said solder (5) further includes a fillet disposed in an inner wall of said recess.
